# EUROPEAN PATENT APPLICATION

(11) **EP 4 654 066 A1**
(43) Date of publication of application: **26.11.2025**
(21) Application number: 23919385.7
(22) Date of filing: 24.10.2023
(51) Int. Cl.: G06F 30/20

(54) **DECISION-MAKING METHOD AND RELATED DEVICE**

(30) Priority: 03.02.2023 CN 202310064374
(71) Applicant: Huawei Cloud Computing Technologies Co., Ltd., Guiyang, Guizhou 550025 (CN)
(72) Inventor: SHAN, Weihua, Shenzhen, Guangdong 518129 (CN); DONG, Yang, Shenzhen, Guangdong 518129 (CN); YIN, Hui, Shenzhen, Guangdong 518129 (CN)
(74) Representative: Goddar, Heinz J.
(86) International application number: PCT/CN2023/126210
(87) International publication number: WO 2024/159821

(57) **Abstract**

This application provides a decision method and a related device, and relates to the field of communication technologies. The decision method includes: obtaining first feature information of a historical real physical environment, where the first feature information includes environment data in a plurality of dimensions; constructing a plurality of physical simulation environments based on the first feature information; obtaining second feature information of an electronic device located in the historical real physical environment, where the second feature information includes body status data in a plurality of dimensions; constructing a digital twin device of the electronic device in a simulation system based on the second feature information; obtaining a decision model based on simulation results of the digital twin device in the plurality of physical simulation environments; and feeding back the decision model to the electronic device. In this application, the plurality of physical simulation environments are constructed based on the historical real physical environment, and simulation is performed in the plurality of physical simulation environments in parallel by using the digital twin device. In this way, the decision model can be quickly and accurately obtained through training, and accuracy of a decision made by the electronic device in a current real scenario is improved.

## Description

This application claims priority to Chinese Patent Application No. 202310064374.9, filed with the China National Intellectual Property Administration on February 3, 2023 and entitled "DECISION METHOD AND RELATED DEVICE", which is incorporated herein by reference in its entirety.

### TECHNICAL FIELD

This application relates to the field of communication technologies, and in particular, to a decision method and a related device.

### BACKGROUND

Because a real scenario constantly changes, a device with a decision need, such as a robot or a self-driving vehicle, usually faces a complex decision challenge, and an incorrect decision may lead to an irreparable loss. For example, the robot detects road condition information, such as a pedestrian, a motor vehicle, a non-motor vehicle, a pet, and a traffic light, at a traffic intersection. The robot may fail to successfully pass the intersection due to interference from the pedestrian, the non-motor vehicle, the pet, or the like before a current traffic light changes, or the robot may avoid the interference and successfully pass the intersection. The robot needs to decide whether to wait for a next traffic light or pass the intersection based on a planned path before the current traffic light changes. For the device with the decision need, how to make a correct decision in the real scenario is a big challenge.

### SUMMARY

In view of this, it is necessary to provide a decision method, to improve accuracy of a decision made by an electronic device in a real scenario.

A first aspect of an embodiment of this application discloses a decision method, applied to a simulation system. The method includes: obtaining first feature information of a historical real physical environment, where the first feature information includes environment data in a plurality of dimensions collected in the historical real physical environment; constructing a plurality of physical simulation environments based on the first feature information, where each physical simulation environment is constructed by using different environment data adjustment policies; obtaining second feature information of an electronic device located in the historical real physical environment, where the second feature information includes body status data of the electronic device in a plurality of dimensions in the historical real physical environment; constructing a digital twin device of the electronic device in the simulation system based on the second feature information; obtaining a decision model based on simulation results of the digital twin device in the plurality of physical simulation environments; and feeding back the decision model to the electronic device.

According to the foregoing technical solution, the different environment data adjustment policies can be used to construct diversified physical simulation environments based on the environment data in a plurality of dimensions in the historical real physical environment. Compared with an existing solution in which a single corresponding physical simulation environment is constructed based on a single real physical environment, the foregoing technical solution can reduce difficulty and time consumed in collecting a large quantity of real physical environments required for physical simulation, and shorten completion time of a simulation task. The digital twin device (constructed based on the body status data of the electronic device in a plurality of dimensions) is used to perform trial and error of training in the diversified physical simulation environments. In this way, presentation and training of a real physical environment and a real electronic device in the simulation system can be implemented. This improves accuracy of a decision subsequently made by the electronic device in a current real scenario. If the simulation system is deployed on a cloud, a computing device cluster on the cloud can also be used to perform multi-channel parallel simulation, which can further shorten the completion time of the simulation task. For example, for a real scenario that constantly changes, multi-channel parallel simulation is performed based on the diversified physical simulation environments constructed based on the environment data in a plurality of dimensions in the real physical environment obtained at a first moment, to obtain the decision model. This can increase a probability that the electronic device on which the decision model is deployed makes a correct decision in the real physical environment at a second moment (after the first moment), and reduce a loss caused by an incorrect decision.

In some embodiments, constructing the plurality of physical simulation environments based on the feature information of the historical real physical environment includes: preprocessing the first feature information, where the preprocessing includes correcting environment data with an anomaly and/or adjusting precision of the environment data; and constructing the plurality of physical simulation environments based on preprocessed first feature information.

According to the foregoing technical solution, the environment data in a plurality of dimensions collected in the historical real physical environment is preprocessed, so that environment data with an obvious anomaly can be removed or corrected, or the precision of the environment data can be adjusted based on a simulation requirement, and an error between the physical simulation environment and the real physical environment can be reduced. This improves accuracy of a decision subsequently made by the electronic device in the real physical environment to which a decision model obtained through simulation in the physical simulation environment is migrated.

In some embodiments, constructing the plurality of physical simulation environments based on the preprocessed first feature information includes: constructing a first physical simulation environment based on the preprocessed first feature information; and modifying environment data in one or more dimensions in the first physical simulation environment to obtain a plurality of second physical simulation environments.

According to the foregoing technical solution, the plurality of physical simulation environments constructed based on the first feature information includes the first physical simulation environment corresponding to the historical real physical environment, and environment data in different dimensions in the first physical simulation environment is adjusted to obtain the plurality of second physical simulation environments. In this way, construction of a corresponding real physical simulation environment is implemented based on environment data in a real physical scenario, and other diversified physical simulation environments are obtained through adjustment based on the real physical simulation environment.

In some embodiments, the decision method further includes: determining a corner case environment corresponding to the historical real physical environment; and adjusting the environment data of the first physical simulation environment based on the corner case environment to obtain a corner case simulation environment.

According to the foregoing technical solution, the corner case simulation environment corresponding to the historical real physical environment is generated, so that uncertainty of the real physical environment can be further simulated. In this way, the digital twin device can perform trial and error of training in comprehensive and diversified physical simulation environments. This improves the accuracy of a decision subsequently made by the electronic device in the current real scenario.

In some embodiments, constructing the digital twin device of the electronic device in the simulation system based on the second feature information includes: preprocessing the second feature information, where the preprocessing includes correcting body status data with an anomaly and/or adjusting precision of the body status data; and constructing the digital twin device of the electronic device in the simulation system based on preprocessed second feature information.

According to the foregoing technical solution, the collected body status data of the electronic device in a plurality of dimensions is preprocessed, so that body status data with an obvious anomaly can be removed or corrected, or the precision of the body status data can be adjusted based on a simulation requirement, and an error between the digital twin device and the electronic device can be reduced. This improves accuracy of a decision subsequently made by the electronic device in the real physical environment to which a decision model obtained through simulation in the physical simulation environment is migrated.

In some embodiments, obtaining the decision model based on the simulation results of the digital twin device in the plurality of physical simulation environments includes: obtaining, through screening the simulation results of the digital twin device in the plurality of physical simulation environments, a simulation result that meets a preset effect requirement; selecting, from the simulation result that meets the preset effect requirement, a simulation result adapted to a current real physical environment of the electronic device as a target simulation result; and obtaining the decision model based on the target simulation result.

According to the foregoing technical solution, the diversified physical simulation environments are constructed based on the different environment data adjustment policies. The preset effect requirement may mean that the digital twin device achieves an expected benefit in the physical simulation environment. For example, during simulation in which the digital twin device passes an intersection with traffic lights, the simulation result that meets the preset effect requirement may mean that the digital twin device successfully passes the intersection before a green traffic light changes. The simulation result being adapted to the current real physical environment of the electronic device may mean that a difference between the physical simulation environment of the simulation result and the current real physical environment in terms of environment data is within a preset rule. The preset rule may be set based on an actual requirement. The simulation result adapted to the current real physical environment of the electronic device is selected from the simulation result that meets the preset effect requirement to generate the decision model, so that the decision model can be applied to the current real physical environment. This improves the accuracy of a decision made by the electronic device in the current real scenario.

In some embodiments, the decision method further includes: if none of the simulation results in the plurality of physical simulation environments meets the preset effect requirement, or no simulation result is adapted to the current real physical environment of the electronic device and meets the preset effect requirement, reconstructing a plurality of physical simulation environments based on the first feature information, and reconstructing a digital twin device of the electronic device in the simulation system based on the second feature information; and reselecting the target simulation result and regenerating the decision model based on simulation results of the reconstructed digital twin device in the plurality of reconstructed physical simulation environments.

According to the foregoing technical solution, if no simulation result meets the preset effect requirement or no simulation result is adapted to the current real physical environment of the electronic device, a new round of simulation can be performed to reselect the target simulation result and regenerate the decision model, so that the finally obtained decision model can be applied to the current real physical environment. In some technical solutions, before a new round of simulation is performed again, the first feature information of the historical real physical environment and the second feature information of the electronic device may alternatively be re-obtained.

According to a second aspect, an embodiment of this application provides a decision apparatus, including: a first obtaining module, configured to obtain first feature information of a historical real physical environment, where the first feature information includes environment data in a plurality of dimensions collected in the historical real physical environment; a first construction module, configured to construct a plurality of physical simulation environments based on the first feature information, where each physical simulation environment is constructed by using different environment data adjustment policies; a second obtaining module, configured to obtain second feature information of an electronic device located in the historical real physical environment, where the second feature information includes body status data of the electronic device in a plurality of dimensions in the historical real physical environment; a second construction module, configured to construct a digital twin device of the electronic device in a simulation system based on the second feature information; a generation module, configured to obtain a decision model based on simulation results of the digital twin device in the plurality of physical simulation environments; and a feedback module, configured to feed back the decision model to the electronic device.

According to a third aspect, an embodiment of this application provides a decision system, including a computing device and an electronic device. A simulation system runs on the computing device. The computing device is configured to: obtain first feature information of a historical real physical environment, where the first feature information includes environment data in a plurality of dimensions collected in the historical real physical environment; construct a plurality of physical simulation environments based on the first feature information, where each physical simulation environment is constructed by using different environment data adjustment policies; obtain second feature information of an electronic device located in the historical real physical environment, where the second feature information includes body status data of the electronic device in a plurality of dimensions in the historical real physical environment; construct a digital twin device of the electronic device in the simulation system based on the second feature information; obtain a decision model based on simulation results of the digital twin device in the plurality of physical simulation environments; and feed back the decision model to the electronic device. The electronic device is configured to make, by using the decision model, a decision in a current real physical environment in which the electronic device is located.

According to a fourth aspect, an embodiment of this application provides a computer-readable storage medium, including computer program instructions. When the computer program instructions are executed by a computing device cluster, the computing device cluster is enabled to perform the decision method provided in the first aspect.

According to a fifth aspect, an embodiment of this application provides a computing device cluster, including at least one computing device. Each computing device includes a processor and a memory. The processor of the at least one computing device is configured to execute instructions stored in the memory of the at least one computing device, to enable the computing device cluster to perform the decision method according to the first aspect.

According to a sixth aspect, an embodiment of this application provides a computer program product. When the computer program product is run by a computing device cluster, the computing device cluster is enabled to perform the decision method according to the first aspect.

According to a seventh aspect, an apparatus is provided. The apparatus has a function of implementing behavior of the computing device cluster in the method according to the first aspect. The function may be implemented by hardware, or may be implemented by hardware executing corresponding software. The hardware or software includes one or more modules corresponding to the foregoing functions.

It may be understood that the decision apparatus according to the second aspect, the simulation system according to the third aspect, the computer-readable storage medium according to the fourth aspect, the computing device cluster according to the fifth aspect, the computer program product according to the sixth aspect, and the apparatus according to the seventh aspect all correspond to the method in the first aspect. Therefore, for beneficial effects that can be achieved by the decision apparatus, the simulation system, the computer-readable storage medium, the computing device cluster, the computer program product, and the apparatus, reference may be made to the beneficial effects in the corresponding method provided above. Details are not described herein again.

### BRIEF DESCRIPTION OF DRAWINGS

FIG. 1 is a diagram of an application environment of a decision method according to an embodiment of this application;
FIG. 2a is a diagram of an architecture of a system in which a computing device cluster makes a simulation decision based on a real scenario according to an embodiment of this application;
FIG. 2b is a diagram of an architecture of a system in which a computing device cluster makes a simulation decision based on a real scenario according to another embodiment of this application;
FIG. 3A and FIG. 3B are a schematic flowchart of making a simulation decision by an electronic device and a computing device cluster according to an embodiment of this application;
FIG. 4 is a diagram of interaction between a computing device cluster and an electronic device according to an embodiment of this application;
FIG. 5 is a schematic flowchart of a decision method according to an embodiment of this application;
FIG. 6 is a diagram of modules of a decision apparatus according to an embodiment of this application;
FIG. 7 is a diagram of a structure of a computing device according to an embodiment of this application; and
FIG. 8 is a diagram of a structure of a computing device cluster according to an embodiment of this application.

### DESCRIPTION OF EMBODIMENTS

It should be noted that "at least one" means one or a plurality of and "a plurality of" means two or more in this application. "And/or" describes an association relationship between associated objects, and represents that three relationships may exist. For example, A and/or B may represent the following cases: Only A exists, both A and B exist, and only B exists, where A and B may be singular or plural. In the specification, claims, and accompanying drawings of this application, the terms "first", "second", "third", "fourth", and so on (if existent) are intended to distinguish between similar objects but do not necessarily indicate a specific order or sequence.

In embodiments of this application, the word such as "example" or "for example" is used to represent an example, an illustration, or a description. Any embodiment or design scheme described as an "example" or "for example" in embodiments of this application should not be explained as being more preferred or having more advantages than another embodiment or design scheme. To be precise, the word such as "example" or "for example" is intended to present a related concept in a specific manner.

For ease of understanding of embodiments of this application, an application scenario of this application is described below. A service scenario described in embodiments of this application is intended to describe the technical solutions of embodiments of this application more clearly, and does not constitute a limitation on the technical solutions provided in embodiments of this application. It can be learned by a person of ordinary skill in the art that, with emergence of a new service scenario, the technical solutions provided in embodiments of this application are also applicable to a similar technical problem.

To facilitate understanding of technical solutions in embodiments of this application, the following first explains some terms in embodiments of this application.

Physical simulation: is also referred to as entity simulation. Usually, a simulation process is based on similarities in physical properties and geometric shapes. Simulation with other properties unchanged is a technology for conducting an experiment on a physical model of a system. A physical simulation system is a geometric similarity or a physical analog of a real system. The geometric similarity means a similarity relationship between systems of different sizes in a same physical process (such as a mechanical motion process or an electrical dynamic process). The physical analogy means that two different physical processes (such as a mechanical motion process and an electrical dynamic process) have same mathematical descriptions, and the two different physical processes can serve as a simulation experimental model for each other.

Corner case (corner case): is also referred to as a pathological case (pathological case), and is a problem or situation in which an operation parameter is beyond a normal range. In addition, in most cases, the corner case is a case in which several environment variables or conditions are at extreme values. Even if the extreme values are within a parameter specification range (or a boundary), the case is also considered as the corner case.

Reality-to-simulation (Real2Sim): A simulation environment is established based on characteristics of a real environment.

To enable a device such as a robot, an industrial device, or a self-driving vehicle to make a correct decision, a method is to construct a corresponding virtual simulation environment based on a real scenario in which the device is located, perform simulation and learning in the virtual simulation environment, and make a decision based on a simulation result. However, for a real scenario that constantly changes, constructing the corresponding virtual simulation environment based on the real scenario increases difficulty in device simulation and learning, and takes a long time. The real scenario may also change over time. The virtual simulation environment constructed based on the real scenario is not comprehensive, which may cause the device to be unable to make a correct decision in a current real scenario based on a learning result.

To resolve the foregoing technical problem, embodiments of this application provide a decision method, so that various simulation scenarios can be constructed based on information about the real scenario, and simulation can be performed in a multi-channel parallel manner. This improves simulation learning efficiency, implements efficient and accurate simulation learning, and reduces a loss caused by an incorrect decision.

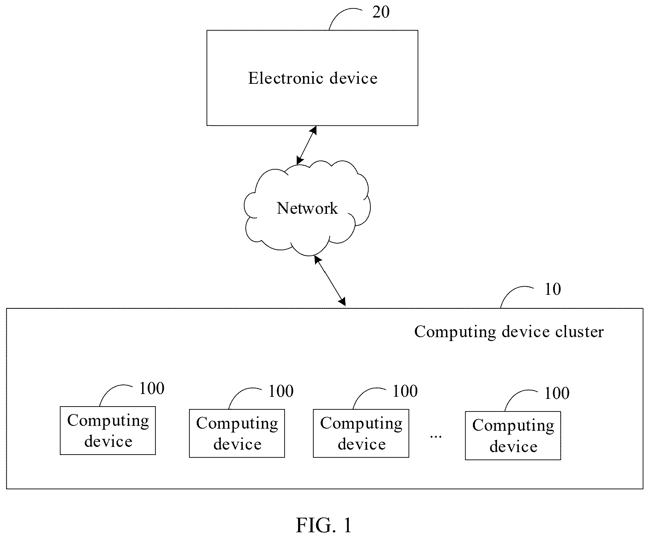

As shown in FIG. 1, an example of a diagram of an application environment of the decision method according to an embodiment of this application is described.

This embodiment may include a computing device cluster 10 and an electronic device 20. The computing device cluster 10 may include at least one computing device 100. The computing device 100 may be a server or a terminal device. The terminal device includes but is not limited to a mobile phone, a foldable electronic device, a tablet computer, a personal computer (personal computer, PC), a laptop computer, a handheld computer, a notebook computer, and the like. The electronic device 20 may be a device that has an intelligent decision requirement or a simulation requirement, and includes but is not limited to a robot, a vehicle, an industrial device, or the like.

The computing device cluster 10 may construct a first physical simulation environment based on feature information of a real physical environment in which the electronic device 20 is located at a moment t1. The feature information of the real physical environment may be environment data in a plurality of dimensions collected in the real physical environment. The first physical simulation environment may also be referred to as a real physical simulation environment, and the first physical simulation environment has feature information that is the same as feature information of the real physical environment in which the electronic device 20 is located at the moment t1. The computing device cluster 10 may further modify environment data in one or more dimensions in the first physical simulation environment to obtain a plurality of second physical simulation environments. The second physical simulation environment may also be referred to as an approximate physical simulation environment. For example, the computing device cluster 10 may modify the environment data in one or more dimensions in the first physical simulation environment to obtain n second physical simulation environments. A value of n can be set based on an actual requirement. This is not limited in this application.

The computing device cluster 10 may further obtain the feature information of the electronic device 20 at the moment t1. The feature information of the electronic device 20 may include body status data in a plurality of dimensions in the real physical environment in which the electronic device 20 is located at the moment t1. The computing device cluster 10 may create, based on the feature information of the electronic device 20, a digital twin device (a virtual electronic device used for simulation in the computing device cluster 10) corresponding to the electronic device 20. The digital twin device may perform parallel simulation training in these constructed physical simulation environments (the first physical simulation environment and the plurality of second physical simulation environments) to obtain a decision model that can be deployed on the electronic device 20. The electronic device 20 may autonomously make a decision in a current real physical environment (for example, a real physical environment in which the electronic device 20 is located at a moment t2 after the moment t1) by using the deployed decision model.

In some embodiments, the decision model may be a model constructed based on a machine learning framework, or may be a decision policy. The decision policy may be applicable only to the current real physical environment. For example, the real physical environment is an intersection with a traffic light, and the decision policy may be a path planned for the electronic device 20 to pass through the intersection.

For example, the electronic device 20 is a quadruped robot. Areal physical environment in which the quadruped robot is located at the moment t1 is an intersection with a traffic light. A traffic light on a sidewalk at the moment t1 turns red. Feature information includes a weather condition, traffic light time, a sidewalk, a zebra crossing, an adult, a child, or a bicycle that is on a same side as the quadruped robot and waits to cross a road, and an adult, a pet dog, and an electric bike that is on an opposite side and waits to cross the road. The first physical simulation environment constructed by the computing device cluster 10 may have feature information that is the same as feature information of the real physical environment in which the quadruped robot is located at the moment t1. The computing device cluster 10 may further modify one or more pieces of environment data in the first physical simulation environment to obtain the plurality of second physical simulation environments. For example, modifying the environment data may include modifying colors of clothes of an adult and a child, randomly increasing or reducing a quantity of adults, children, bicycles, pet dogs, electric bikes, and the like that wait to cross the road, changing a weather condition, and the like. The computing device cluster 10 may create a corresponding digital twin device based on the feature information of the quadruped robot. The digital twin device may perform parallel simulation training in these constructed physical simulation environments (the first physical simulation environment and the plurality of second physical simulation environments) to obtain a decision model that can be deployed on the quadruped robot. The quadruped robot may autonomously make a decision by using the deployed decision model when the traffic light turns green (for example, the traffic light on the sidewalk turns green at the moment t2 after the moment t1).

In some embodiments, feature information of a real physical environment in which the electronic device 20 is located and body status data of the electronic device 20 may be collected by the electronic device 20, or may be collected by another collection device independent of the electronic device 20. This is not limited in this application. The body status data of the electronic device 20 may include a weight, a material of a walking structure, wear information of the walking structure, and the like.

Feature information of various real physical environments in which the electronic device 20 is located may be collected and uploaded by a user or a manufacturer of the electronic device 20 to the computing device cluster 10, or may be uploaded by the electronic device 20 or a collection device to the computing device cluster 10. This is not limited in this application. The computing device cluster 10 may construct a corresponding real physical simulation environment based on feature information of each real physical environment, and may derive a plurality of approximate physical simulation environments based on each real physical simulation environment. The computing device cluster 10 may further obtain feature information of the electronic device 20 located in the various real physical environments. The computing device cluster 10 may create a digital twin device corresponding to the electronic device 20. The digital twin device may perform simulation training and learning in these constructed physical simulation environments, to obtain a decision model that can be deployed on the electronic device 20. The decision model may be a model constructed based on a machine learning framework, and the electronic device 20 may autonomously make a decision by using the deployed decision model.

For example, the electronic device 20 is a quadruped robot. Before the quadruped robot is launched for sale, a manufacturer of the quadruped robot may collect body status data of a quadruped robot used for internal testing and feature information of various real physical environments, and upload the body status data and the feature information to the computing device cluster 10 for simulation training to obtain a decision model. Then, the decision model is deployed on a quadruped robot for sale. In this way, the quadruped robot purchased by a user may input collected feature information of the real physical environments to the decision model in an actual walking process, and the quadruped robot may autonomously make a walking decision based on a result output by the decision model.

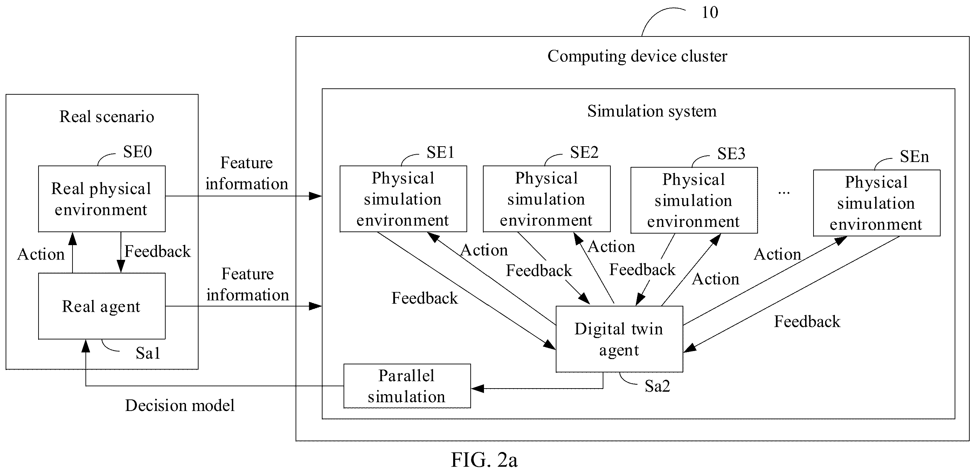

With reference to FIG. 2a, the following describes, as an example, a diagram of an architecture of a system in which a computing device cluster implements a simulation decision based on a real scenario according to an embodiment of this application.

This embodiment may include information about the real scenario and a simulation system that is used to simulate the real scenario. The simulation system may be deployed in the computing device cluster 10. The information about the real scenario may include a real physical environment SE0 and a real agent Sa1 in the real physical environment SE0. The real agent Sa1 may be a device that has an intelligent decision requirement or a simulation requirement. For example, the real agent Sa1 may be the electronic device 20 shown in FIG. 1. The real agent Sa1 may perform an action in the real physical environment SE0, and the real physical environment SE0 may generate corresponding feedback information for the action. For example, the real physical environment SE0 may receive the action performed by the real agent Sa1, evaluate the action, and perform conversion into the corresponding feedback information.

The simulation system may construct a plurality of physical simulation environments SE1 to SEn based on feature information of the real physical environment SE0. The physical simulation environment SE1 may be a real physical simulation environment having feature information that is the same as the feature information of the real physical environment SE0. The physical simulation environments SE2 to SEn may be approximate physical simulation environments obtained by modifying environment data in one or more dimensions in the physical simulation environment SE1. The simulation system may further construct a digital twin agent Sa2 based on feature information of the real agent Sa1, and the digital twin agent Sa2 may have feature information that is the same as the feature information of the real agent Sa1.

In some embodiments, the simulation system may construct the physical simulation environments SE2 to SEn in one or a combination of the following manners: modifying environment data of the physical simulation environment SE0 in a domain randomization manner, randomly replacing the environment data of the physical simulation environment SE0, adding new environment data to the physical simulation environment SE0, and removing some environment data of the physical simulation environment SE0.

In some embodiments, for the n physical simulation environments SE1 to SEn, the computer cluster 10 may implement multi-channel parallel simulation by using m computing devices 100 or m computing instances. That is, the computer cluster 10 may simulate m physical simulation environments SE1 to SEm in parallel at a time. This improves simulation efficiency. m is less than or equal to n.

As shown in FIG. 2a, the digital twin agent Sa2 may perform action tests in the m physical simulation environments SE1 to SEm, or m digital twin agents Sa2 may perform action tests in the m physical simulation environments SE1 to SEm respectively. Each of the physical simulation environments SE1 to SEm may generate corresponding feedback information for the action tests. A large quantity of action trials and errors are performed by constructing the digital twin agent Sa2 in the computer cluster 10, so that a loss caused by practice of the real agent Sa1 in the real physical environment SE0 can be reduced.

In some embodiments, the computer cluster 10 may select, based on a simulation result of the digital twin agent Sa2 in each of the physical simulation environments SE1 to SEn, a simulation result that is adapted to the real physical environment SE0 and has optimal effect, obtain a decision model based on the simulation result having the optimal effect, and feed back the decision model to the real agent Sa1. For example, a rule for environment adaptation may be predefined (for example, determined based on a degree of a similarity between environment features), and physical simulation environments that are in the plurality of physical simulation environments SE1 to SEn and that are adapted to the real physical environment SE0 are determined based on the rule for environment adaptation. Then, the simulation result having the optimal effect is selected from these physical simulation environments, and the decision model is obtained based on the simulation result having the optimal effect and fed back to the real agent Sa1. That the decision model is obtained based on the simulation result having the optimal effect may mean that an action performed by the real agent Sa1 in the real physical environment SE0 by using the decision model is the same as an action performed by the digital twin agent Sa2 in the physical simulation environment to obtain the simulation result having the optimal effect through simulation.

In some embodiments, the real agent Sa1 may make a decision in the real physical environment SE0 by using the decision model. If a benefit of the decision made by the real agent Sa1 in the real physical environment SE0 by using the decision model achieves an expected benefit, the decision model may be used as a final decision model of the real agent Sa1 in the real physical environment SE0. If the benefit of the decision made by the real agent Sa1 in the real physical environment SE0 by using the decision model does not achieve the expected benefit, the feature information of the real physical environment SE0 and the feature information of the real agent Sa1 may be re-collected, and a plurality of physical simulation environments and the digital twin agent Sa2 are reconstructed, to perform a new round of simulation.

In some embodiments, the simulation result that is adapted to the real physical environment SE0 and that has the optimal effect may be determined based on a preset simulation evaluation standard. An evaluation factor in the simulation evaluation standard may be set based on the real agent Sa1 and a real physical environment in which the real agent Sa1 is located. The simulation evaluation standard may be prestored in the computing device cluster 10, or the computing device cluster may provide a communication interface for setting the simulation evaluation standard, and a user or a manufacturer of the real agent Sa1 performs customization through the communication interface. For example, the real agent Sa1 is a quadruped robot, and the real physical environment SE0 is an intersection with a traffic light. The simulation result having the optimal effect may be that time used for successfully passing the intersection before the green traffic light changes is the shortest, and a quantity of times of changing a route direction is the smallest.

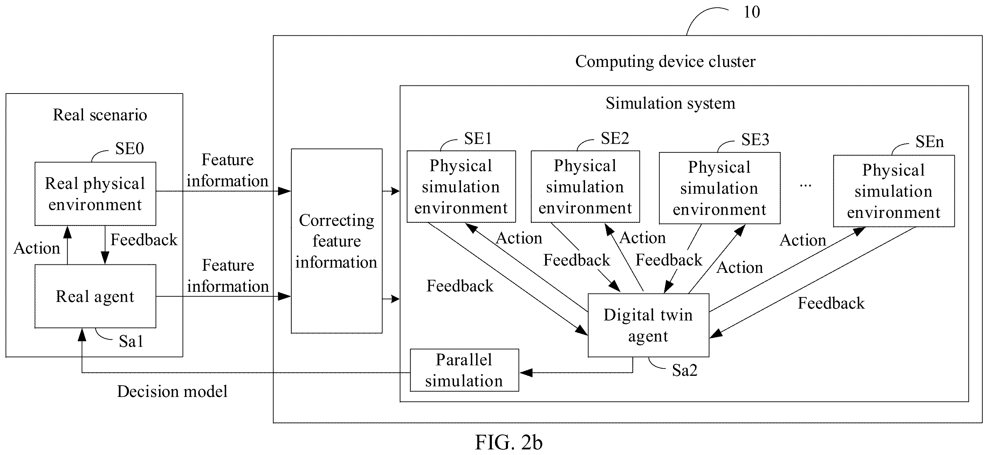

As shown in FIG. 2b, before constructing the physical simulation environment based on the feature information of the real physical environment SE0, the computing device cluster 10 may correct the feature information of the real physical environment SE0 according to a feature value precision requirement of the physical simulation environment, or correct feature information with an obvious anomaly of the real physical environment SE0. For example, the feature information with the obvious anomaly may be caused by an anomaly that occurs in a feature collection sensor in a feature information collection phase. A feature value range of the feature information may be set based on the real physical environment SE0. Feature information beyond a corresponding feature value range is considered as feature information with an anomaly. The computing device cluster 10 may attempt to recalculate a feature value of the feature information. If the computing device cluster 10 cannot recalculate the feature value of the feature information, the computing device cluster 10 may require to re-collect and upload feature information. Before constructing the digital twin agent Sa2 based on the feature information of the real agent Sa1, the computing device cluster 10 may also correct the feature information of the real agent Sa1 according to a feature value precision requirement of the digital twin agent, or correct feature information with an obvious anomaly of the real agent Sa1.

The computing device cluster 10 may further construct a corner case simulation environment based on the feature information of the real physical environment SE0 for simulation. This can improve accuracy of the simulation decision. For example, the computing device cluster 10 may first determine whether there is a corner case environment corresponding to the real physical environment SE0. If there is the corner case environment, the computing device cluster 10 may adjust the feature information of the real physical environment SE0 based on the corner case environment, and construct the corner case simulation environment based on adjusted feature information of the real physical environment SE0.

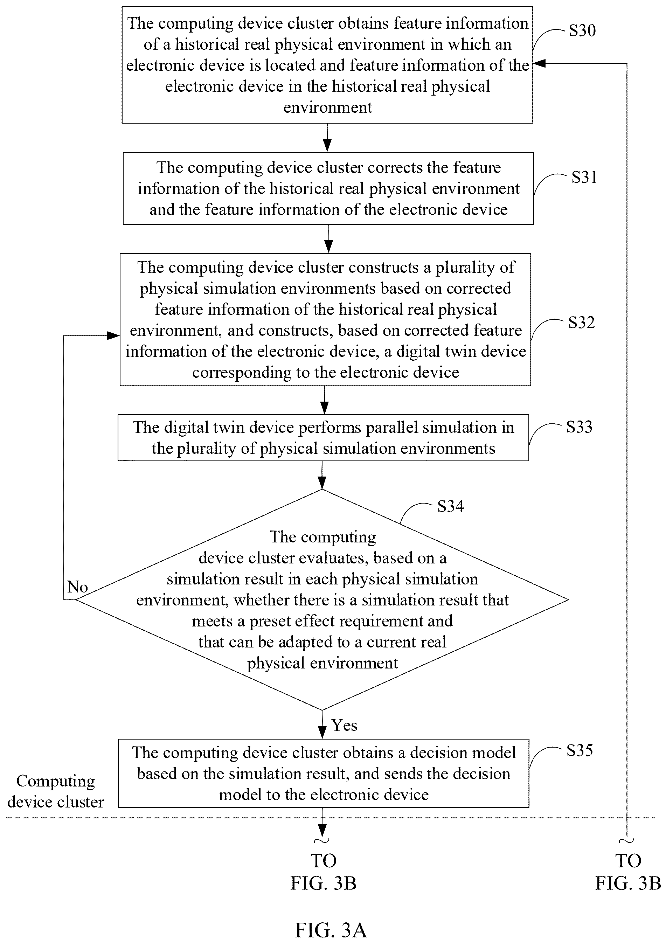

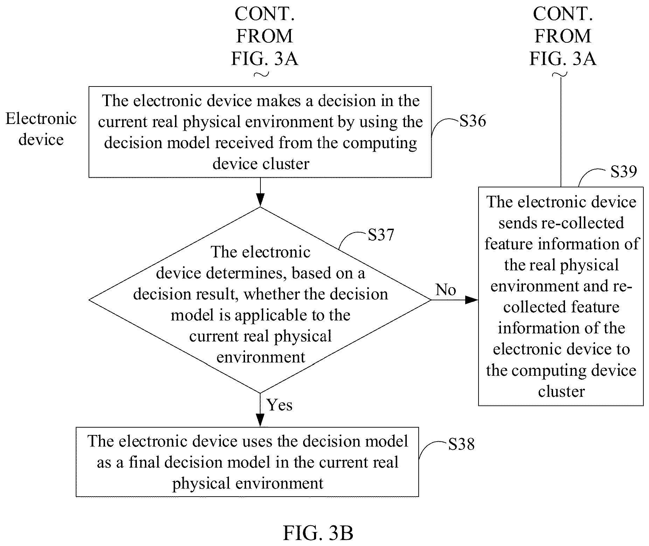

FIG. 3A and FIG. 3B are an example of a schematic flowchart of making a simulation decision by an electronic device and a computing device cluster according to an embodiment of this application.

The electronic device 20 may communicate with the computing device cluster 10 via a communication network. In this embodiment, an example in which the computing device cluster 10 performs simulation based on a historical real physical environment in which the electronic device 20 is located is used. A simulation decision process may specifically include the following steps.

S30: The computing device cluster 10 obtains feature information of the historical real physical environment in which the electronic device 20 is located and feature information of the electronic device 20 in the historical real physical environment.

In some embodiments, the feature information of the historical real physical environment in which the electronic device 20 is located and the feature information of the electronic device 20 in the historical real physical environment may be collected by the electronic device 20, or may be collected by another device and transmitted to the electronic device 20. This is not limited in this application.

In some embodiments, the historical real physical environment may be a real physical environment in which the electronic device 20 is located at a moment t1. The computing device cluster 10 may construct a plurality of physical simulation environments based on the real physical environment at the moment t1. The electronic device 20 may make a decision in a current real physical environment based on simulation results in the physical simulation environments. The current real physical environment may be a real physical environment at a moment t2 after the moment t1. The computing device cluster 10 obtains the feature information of the historical real physical environment in which the electronic device 20 is located and the feature information of the electronic device 20, to synchronize the real physical environment in which the electronic device 20 is located at the moment t1 and a device body status.

S31: The computing device cluster 10 corrects the feature information of the historical real physical environment and the feature information of the electronic device 20.

In some embodiments, the computing device cluster 10 may correct the feature information of the real physical environment and the feature information of the electronic device 20 according to a simulation feature value precision requirement, or correct feature information with an obvious anomaly.

S32: The computing device cluster 10 constructs a plurality of physical simulation environments based on corrected feature information of the historical real physical environment, and constructs, based on corrected feature information of the electronic device 20, a digital twin device corresponding to the electronic device 20.

In some embodiments, the plurality of physical simulation environments may include a real physical simulation environment and an approximate physical simulation environment. The computing device cluster 10 may construct the real physical simulation environment based on the corrected feature information of the historical real physical environment, and obtain a plurality of approximate physical simulation environments by adjusting environment data in one or more dimensions in the real physical simulation environment.

S33: The digital twin device performs parallel simulation in the plurality of physical simulation environments.

S34: The computing device cluster 10 evaluates, based on a simulation result in each physical simulation environment, whether there is a simulation result that meets a preset effect requirement and that can be adapted to the current real physical environment.

In some embodiments, the computing device cluster 10 determines, based on a simulation evaluation standard, whether there is the simulation result that meets the preset effect requirement and that can be adapted to the current real physical environment. For example, the simulation result that meets the preset effect requirement and that can be adapted to the current real physical environment may mean that simulation effect in the physical simulation environment meets the preset effect requirement, and it is determined, based on a degree of a similarity between environment features, that the physical simulation environment is adapted to the current real physical environment.

S35: If there is the simulation result that meets the preset effect requirement and that can be adapted to the current real physical environment, the computing device cluster 10 obtains a decision model based on the simulation result, and sends the decision model to the electronic device 20.

In some embodiments, if there are a plurality of simulation results that meet the preset effect requirement and that can be adapted to the current real physical environment, a simulation result having optimal simulation effect may be further selected from the simulation results, and the computing device cluster 10 may further obtain a decision model based on the simulation result having the optimal effect.

In some embodiments, if no simulation result meets the preset effect requirement, or no simulation result can be adapted to the current real physical environment, the computing device cluster 10 may perform step S32 again, to reconstruct a plurality of physical simulation environments and a digital twin device of the electronic device 20, and perform a new round of simulation decision.

S36: The electronic device 20 makes a decision in the current real physical environment by using the decision model received from the computing device cluster 10.

S37: The electronic device 20 determines, based on a decision result, whether the decision model is applicable to the current real physical environment.

In some embodiments, the electronic device 20 may determine, based on whether a benefit of the decision made by using the decision model in the current real physical environment achieves an expected benefit, whether the decision model is applicable to the current real physical environment. If the benefit of the decision achieves the expected benefit, it may be considered that the decision model is applicable to the current real physical environment. If the benefit of the decision does not achieve the expected benefit, it may be considered that the decision model is not applicable to the current real physical environment. For example, the expected benefit is to successfully pass an intersection before a green traffic light changes. If the electronic device 20 makes, by using the decision model when a green traffic light on a sidewalk is on, a decision that the intersection can be passed before the green traffic light changes, and the electronic device 20 successfully passes the intersection based on a planned route before the current green traffic light changes, it may be considered that the benefit of the decision achieves the expected benefit, and the decision model is applicable to the current real physical environment.

S38: If the decision model is applicable to the current real physical environment, the electronic device 20 uses the decision model as a final decision model in the current real physical environment.

S39: If the decision model is not applicable to the current real physical environment, the electronic device 20 sends re-collected feature information of the real physical environment and re-collected feature information of the electronic device 20 to the computing device cluster 10.

In some embodiments, if the decision model is not applicable to the current real physical environment, the electronic device 20 may send the re-collected feature information of the real physical environment and the re-collected feature information of the electronic device 20 to the computing device cluster 10, so that the computing device cluster 10 may perform step S30 again to perform a new round of simulation decision. For example, the decision model is not applicable to the current real physical environment, and a failure cause may be analyzed to determine whether some feature information of the real physical environment is not collected or some feature information of the electronic device 20 is not collected. The re-collected feature information of the real physical environment and the re-collected feature information of the electronic device 20 are sent to the computing device cluster 10 to re-perform a round of simulation decision.

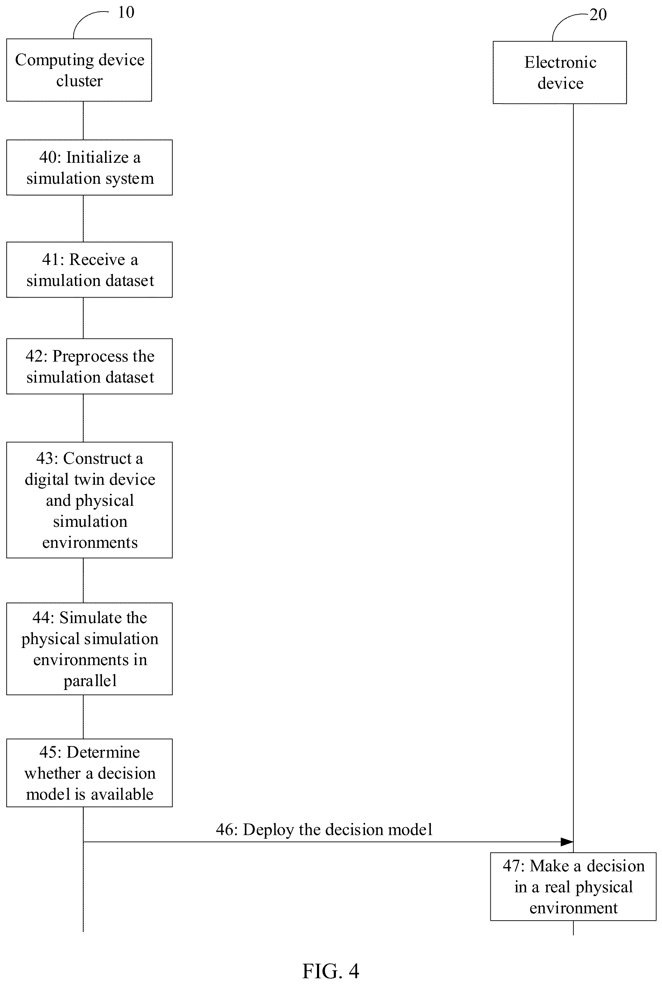

With reference to FIG. 4, the following describes an example of a diagram of interaction between the electronic device and the computing device cluster according to an embodiment of this application.

In this embodiment, an example in which the electronic device 20 is a quadruped robot, and the computing device cluster 10 is deployed with a simulation system that can simulate a real physical environment in which the electronic device 20 is used for description. It is assumed that feature information of the real physical environment in which the electronic device 20 is currently located includes: sunny weather, a breeze, an interaction, a traffic light, a sidewalk, a zebra crossing, a plurality of pedestrians waiting for a green traffic light to pass a sidewalk, a vehicle driving normally according to a traffic light, and road surface information of a sidewalk (including but not limited to a ground levelness degree and a ground dryness/slipperiness degree). Feature information of the electronic device 20 includes: the quadruped robot, the quadruped robot waiting for a green traffic light to pass a sidewalk, a weight of the quadruped robot, a sole material, and sole wear information. A decision goal is that the electronic device 20 successfully passes the sidewalk and reaches an opposite side before a green traffic light changes. Factors that affect achievement of the goal of the electronic device 20 may include: remaining time of the green traffic light, a status of the electronic device 20 (such as a weight of the electronic device, a sole material, and sole wear information), road surface information of the sidewalk (such as a dry road surface, a puddle on the road surface, water accumulated on the road surface, and snow accumulated on the road surface), pedestrian interference (such as avoiding a pedestrian or contact/collision with a pedestrian), and the like. A speed at which the electronic device 20 passes the intersection is affected by factors such as the status of the electronic device 20, the road surface information of the sidewalk, and the pedestrian interference. For example, when the road surface is dry, there is a large friction coefficient between a foot of the quadruped robot and the road surface, and the quadruped robot may move at a high movement speed. However, on a rainy or snowy day, there is a small friction coefficient between the foot of the quadruped robot and the road surface, and the quadruped robot needs to move at a low movement speed to avoid falling down. When there are a large number of pedestrians, the quadruped robot may need to adjust a movement direction for a plurality of times to avoid the pedestrians.

A process of the interaction between the electronic device 20 and the computing device cluster 10 may include the following steps.

40: The computing device cluster 10 initializes the simulation system.

In some embodiments, that the computing device cluster 10 initializes the simulation system may be initializing a scenario library, a feature library, a corner case library, a simulation evaluation standard, and the like that are configured in the simulation system, or initializing a scenario library, a feature library, a corner case library, a simulation evaluation standard, and the like that are customized by a user and that are imported to the simulation system through a communication interface.

For example, the scenario library may include a road scenario library and a weather scenario library. The road scenario library includes but is not limited to: an urban traffic road, a rural road, a road inside a campus/scenic spot, a mountain road, forest land, and the like. The weather scenario library includes but is not limited to: spring, summer, autumn, winter, sun, cloud, rain, snow, hail, fog, a wind speed, and the like. The feature library includes but is not limited to: an elderly person, an adult (except the elderly person), a child, a teenager, a cat, a dog, a vehicle, a motorcycle, a bicycle, a handcart, and the like. The corner case library includes but is not limited to: extreme weather (such as a storm and a snowstorm), an ultra-large crowd pedestrian (for example, a quantity of pedestrians waiting for the green traffic light to pass the sidewalk is greater than a preset threshold), a vehicle running a red traffic light, and the like. The simulation evaluation standard includes but is not limited to evaluation factors such as time of passing an intersection and a quantity of times of changing a direction of a moving route.

41: The computing device cluster 10 receives a simulation dataset.

In some embodiments, the simulation dataset may be submitted by the electronic device 20 to the computing device cluster 10, or may be submitted by a user or a manufacturer of the electronic device 20 to the computing device cluster 10. For example, the user or the manufacturer of the electronic device 20 may access the computing device cluster 10 by using a terminal device, and submit the simulation dataset to the computing device cluster 10 by using the terminal device, to trigger the simulation system deployed in the computing device cluster 10 to perform simulation.

In some embodiments, the simulation dataset submitted to the computing device cluster 10 may include a plurality of groups of simulation data. Each group of simulation data may include the feature information of the real physical environment in which the electronic device 20 is located and the feature information of the electronic device 20 in the real physical environment. The plurality of groups of simulation data may correspond to different types of real physical environments. For example, the feature information of the real physical environment in a group of simulation data includes: an urban traffic road, an intersection with a traffic light, green traffic light time, sunny weather, a wind speed, a sidewalk length, a quantity of pedestrians (a quantity of pedestrians of different types in a same direction and a quantity of pedestrians of different types in an opposite direction), and a levelness degree of the sidewalk; and the feature information of the electronic device 20 includes: the quadruped robot, the sole material, the weight of the robot (the weight of the robot and a weight of carried materials), and the sole wear degree information.

42: The computing device cluster 10 preprocesses the simulation dataset.

In some embodiments, the preprocessing may include: correcting feature information with an obvious anomaly in each group of simulation data, and/or correcting related feature information according to a simulation feature value precision requirement, to avoid an obvious deviation between the simulation data and the feature information of the real physical environment. For example, the quadruped robot collects some feature information with an obvious anomaly due to sole wear, component damage, sensor anomaly/sensor noise, or other non-deterministic external factors (collision or contact with a person or an object, or the like). The simulation dataset may be preprocessed to correct the some feature information with an obvious anomaly, to avoid the deviation between the simulation data and the feature information of the real physical environment, which leads to a failure to obtain a correct simulation result.

For example, the feature information of the real physical environment includes a sidewalk length, and a sidewalk length recorded in a group of simulation data is 30±0.5 m. The computing device cluster 10 may obtain a more accurate sidewalk length by recognizing and converting a sidewalk image collected by the electronic device 20, for example, a corrected sidewalk length of 30.25 m. For example, the feature information of the real physical environment includes a wind speed, and a wind speed recorded in a group of simulation data is 4 m/s. If a precision requirement of the wind speed defined in the current simulation decision is to be accurate to two decimal places, the computing device cluster 10 may recalculate the wind speed based on wind speed measurement data in the simulation data, for example, a corrected wind speed of 4.09 m/s.

43: The computing device cluster 10 constructs, based on a preprocessed simulation dataset, a digital twin device and a plurality of physical simulation environments corresponding to each real physical environment, and constructs a corner case simulation environment based on each real physical environment and the corner case library.

In some embodiments, for each group of simulation data, the computing device cluster 10 may construct the digital twin device based on preprocessed feature information of the electronic device 20, and construct the plurality of physical simulation environments based on preprocessed feature information of the real physical environment. For example, the simulation dataset includes 100 groups of simulation data. For each group of simulation data, the computing device cluster 10 constructs 100 physical simulation environments based on the preprocessed feature information of the real physical environment. That is, 100*100 physical simulation environments may be finally obtained. This implements diversity of the simulation environments and improves training effect of a decision model.

For example, based on a real physical environment, a plurality of physical simulation environments may be generated in one or a combination of the following manners: a. Physical simulation environments with different weather conditions are generated by using the weather scenario library. b. Environment data of the real physical environment is randomly replaced. For example, an adult is replaced with a dog, a child, or an elderly person (a walking speed of different types of dynamic objects varies, which may affect a probability of collision between the quadruped robot and the dynamic objects or route selection). c. Colors of pedestrian's clothes (affecting robot's visual perception), a levelness degree of a zebra crossing (affecting robot's balance and walking speed), and the like are adjusted in a domain randomization manner.

In some embodiments, for each real physical environment involved in the simulation dataset, the computing device cluster 10 may determine, based on a preset rule, whether the corner case simulation environment needs to be generated. The preset rule may be defined by the user or the manufacturer of the electronic device 20. An example in which the quadruped robot autonomously makes a walking simulation decision is used. For a real physical environment that is an indoor road section, a corner case simulation environment including extreme weather does not need to be generated. For a real physical environment that is an outdoor road section, a corner case simulation environment including extreme weather is generated. For a real physical environment that is an outdoor road section without an intersection, a corner case simulation environment that includes a vehicle running a red traffic light does not need to be generated.

44: The computing device cluster 10 executes simulation of the digital twin device in the plurality of physical simulation environments in parallel.

In some embodiments, the physical simulation environments in which the computing device cluster 10 performs simulation may include the physical simulation environment and the corner case simulation environment that are generated based on each real physical environment. The computing device cluster 10 includes a plurality of computing devices 100 or a plurality of computing instances. The plurality of computing devices 100 or the plurality of computing instances may be used to simulate the plurality of physical simulation environments in parallel, to obtain a decision model through training, and shorten training time of the decision model. For example, the decision model may be constructed by using a preset machine learning framework. The machine learning framework used by the decision model is not limited in this application. The computing device cluster 10 simulates each physical simulation environment, so that the digital twin device can make a corresponding decision in each physical simulation environment by using the decision model. A benefit of the corresponding decision is a simulation result of the physical simulation environment.

For example, a same to-be-trained decision model may be deployed on each computing device 100, a physical simulation environment used for training is divided into a plurality of subdatasets, and the plurality of subdatasets are distributed to each computing device 100. Each computing device 100 independently trains the decision model by using data in a subdataset corresponding to the computing device 100. In each training iteration process, a gradient value obtained by each computing device 100 through calculation may be synchronized to another computing device 100, so that each computing device 100 can obtain an average gradient value in one iteration process. The average gradient value is an average value of gradients of the computing devices 100 in a same iteration process. The computing devices 100 may update parameters of respective decision models based on the average gradient value. This can improve a convergence speed of the decision model, and further improve efficiency of training the decision model.

An example in which any of the plurality of physical simulation environments is simulated is used. The digital twin device attempts to pass an intersection before a green traffic light changes through a large quantity of trials and errors in the physical simulation environment. After training of preset time or after training of a preset quantity of times, if there are m walking routes in which the digital twin device passes the intersection before the current green traffic light changes after training of preset time or after training of a preset quantity of times, an optimal walking route may be selected from the m walking routes as a simulation result of the physical simulation environment. For example, the optimal walking route may be a walking route with shortest passing time or a walking route with a minimum quantity of changes in a walking route direction in the m walking routes, or intersection passing time and a quantity of changes in a walking route direction is comprehensively considered to select the optimal walking route (for example, different weight coefficients are assigned to the intersection passing time and the quantity of changes in the walking route direction, to comprehensively consider the intersection passing time and the quantity of changes in the walking route direction). After the training of the preset time or after the training of the preset quantity of times, if the digital twin device does not find a walking route in which the digital twin device can pass the intersection before the green traffic light changes, that the digital twin device cannot pass the intersection before the current green traffic light changes, and waits for a next green traffic light and then decides whether to pass the intersection may be used as the simulation result of the physical simulation environment.

In some embodiments, that the computing device cluster 10 simulates the plurality of physical simulation environments in parallel may mean that the plurality of computing instances simulate the plurality of physical simulation environments in parallel. The computing instance may include at least one of a physical host (the computing device 100), a virtual machine, and a container. For example, each computing instance simulates one physical simulation environment.

45: The computing device cluster 10 determines, based on the simulation result of each physical simulation environment, whether the decision model is available.

For example, the simulation result of each physical simulation environment may be pre-calibrated to indicate that the intersection can be passed before the current green traffic light changes, or the intersection cannot be passed before the current green traffic light changes, and waits for a next green traffic light and then decides whether to pass the intersection. The computing device cluster 10 may evaluate, based on the simulation result of each physical simulation environment and a pre-calibrated simulation result, accuracy of a decision output by the decision model, to determine whether the decision model is available. If the accuracy of the decision made by the decision model is greater than or equal to a preset value, it is determined that the decision model is available. If the accuracy of the decision made by the decision model is less than the preset value, it is determined that the decision model is unavailable. The preset value may be set based on an actual requirement. This is not limited in this application.

In some embodiments, if it is determined that the decision model is unavailable, the physical simulation environment may be regenerated based on preprocessed simulation dataset, and each physical simulation environment is resimulated. Alternatively, the simulation dataset is repreprocessed, and then the physical simulation environment is regenerated based on the repreprocessed simulation dataset, and each physical simulation environment is resimulated.

46: If it is determined that the decision model is available, the computing device cluster 10 deploys the decision model on the electronic device 20.

In some embodiments, because a hardware resource (a CPU and memory) of the computing device 100 is different from a hardware resource of the electronic device 20, to enable the electronic device 20 to better run the decision model, the decision model may be optimized and converted, and then a converted decision model is deployed on the electronic device 20. For example, the electronic device 20 may download the decision model from the computing device cluster 10, or the computing device cluster 10 pushes the decision model to the electronic device 20.

For example, a network architecture, a hyperparameter, a loss function, and the like of the decision model may be optimized, and a decision model constructed and trained based on a first development framework (for example, a development framework applicable to the computing device 100) is converted into a decision model based on a second development framework (for example, a development framework applicable to the electronic device 20), and then the decision model is deployed on the electronic device 20.

47: The electronic device 20 makes a decision in the real physical environment by using the decision model.

In some embodiments, whether the electronic device 20 on which the decision model is deployed may make a correct decision at a plurality of intersections (real physical environments) with traffic lights may be tested. For example, the correct decision may be a decision that the intersection can currently be passed, and the quadruped robot passes the intersection before the green traffic light changes based on a planned route. An incorrect decision may be a decision that the intersection can currently be passed, and the quadruped robot does not pass the intersection before the green traffic light changes based on the planned route, or a decision for passing the intersection before the green traffic light changes cannot be obtained for a long time, and that the quadruped robot keeps waiting for a next green traffic light.

If the electronic device 20 on which the decision model is deployed makes correct decisions at all the plurality of intersections with traffic lights, the decision model may be used as a model that can be finally deployed on the electronic device 20. If the electronic device 20 on which the decision model is deployed makes the incorrect decision at one or more intersections with traffic lights, feature information of a real physical environment in which the incorrect decision is made may be collected, and added to the simulation dataset. The computing device cluster 10 reconstructs a simulation environment and resimulates the simulation environment based on an updated simulation dataset for training, to obtain a new decision model, and then deploys the new decision model on the electronic device 20 for making a decision.

In some embodiments, a reason for making the incorrect decision may be further analyzed, to determine whether the incorrect decision is made because some feature information of the real physical environment is not collected or some feature information of the electronic device 20 is not collected, or some feature information is incorrectly corrected. This helps improve collection of the feature information of the real physical environment or the feature information of the electronic device 20, so that the data in the simulation dataset is more accurate and comprehensive.

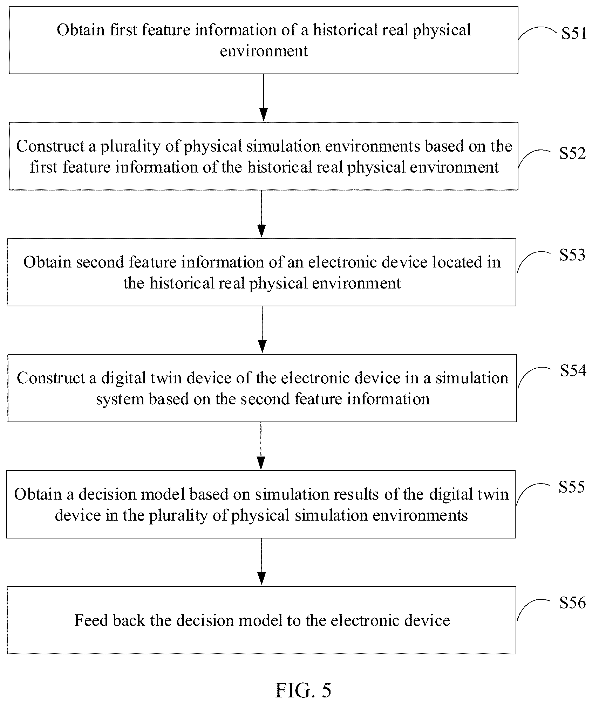

FIG. 5 is a flowchart of steps of a decision method according to an embodiment of this application. The decision method may be applied to a simulation system. Based on different requirements, a sequence of the steps in the flowchart may be changed, and some steps may be omitted. In this embodiment, the decision method may include the following steps.

Step S51: Obtain first feature information of a historical real physical environment.

In some embodiments, the simulation system may be deployed in the computing device cluster 10. The historical real physical environment may be a real physical environment in which the electronic device 20 is located at a moment t1. The computing device cluster 10 may construct a plurality of physical simulation environments based on the real physical environment at the moment t1. The electronic device 20 may make a decision in a current real physical environment based on simulation results in the plurality of physical simulation environments. The current real physical environment may be a real physical environment at a moment t2 after the moment t1. The first feature information may include environment data in a plurality of dimensions collected in the historical real physical environment. For example, the historical real physical environment is an intersection with a traffic light. The first feature information may include a weather condition, traffic light time, a sidewalk length, information about a pedestrian that is on a same side as the electronic device 20 and waits to cross a road, and information about a pedestrian that is on an opposite side and waits to cross the road.

Step S52: Construct a plurality of physical simulation environments based on the first feature information of the historical real physical environment.

In some embodiments, the computing device cluster 10 may construct the plurality of physical simulation environments based on the first feature information of the historical real physical environment, and each physical simulation environment may be constructed by using different environment data adjustment policies. For example, the computing device cluster 10 may first construct the first physical simulation environment based on the first feature information of the historical real physical environment. The computing device cluster 10 may further modify environment data in one or more dimensions in the first physical simulation environment to obtain a plurality of second physical simulation environments. For example, the computing device cluster 10 may modify the environment data of the first physical simulation environment in a domain randomization manner to obtain the plurality of second physical simulation environments.

In some embodiments, the computing device cluster 10 may also determine whether there is a corner case environment corresponding to the historical real physical environment based on the historical real physical environment. If determining that there is the corner case environment, the computing device cluster 10 may further construct the corner case simulation environment by setting one or more pieces of environment data of the first physical simulation environment to an extreme case.

In some embodiments, before step S52 is performed, the first feature information of the historical real physical environment may alternatively be preprocessed, to avoid a deviation between simulation environment data in the simulation system and environment data of the historical real physical environment, which subsequently leads to a failure to obtain a correct simulation result. The preprocessing may include correcting environment data with an anomaly and/or adjusting precision of the environment data.

Step S53: Obtain second feature information of the electronic device 20 located in the historical real physical environment.

In some embodiments, the second feature information includes body status data of the electronic device 20 in a plurality of dimensions in the historical real physical environment. For example, the body status data in a plurality of dimensions may include weights (a weight of the electronic device and a weight of carried materials), a material of a walking structure, wear information of the walking structure, and the like.

Step S54: Construct a digital twin device of the electronic device 20 in the simulation system based on the second feature information.

In some embodiments, before step S55 is performed, the second feature information of the electronic device 20 may alternatively be preprocessed, to avoid a deviation between body status data of the digital twin device in the simulation system and the body status data of the electronic device in the historical real physical environment, which subsequently leads to a failure to obtain a correct simulation result. The preprocessing may include correcting body status data with an anomaly and/or adjusting precision of the body status data.

Step S55: Obtain a decision model based on simulation results of the digital twin device in the plurality of physical simulation environments.

In some embodiments, the decision model may be a model constructed based on a machine learning framework, or may be a decision policy. The decision policy may be applicable only to the current real physical environment.

For example, if the first feature information, obtained by the computing device cluster 10, of the historical real physical environment indicates a historical real physical environment at a moment (the moment t1), the decision model may be used by the electronic device 20 to make a decision in the real physical environment at the moment t2 after the moment t1. The computing device cluster 10 may first obtain, through screening the simulation results of the digital twin device in the plurality of physical simulation environments, simulation results whose simulation effect meets a preset effect requirement. The preset effect requirement may mean that the digital twin device achieves an expected benefit in the physical simulation environment, for example, successfully passing an intersection before a green traffic light changes. Then, the computing device cluster 10 selects, as a target simulation result, a simulation result that can be adapted to the real physical environment at the moment t2 and that has optimal simulation effect from the simulation results whose simulation effect meets the preset effect requirement, and obtains the decision model based on the target simulation result. To be specific, if there are a plurality of simulation results that achieve the expected benefit and that can be adapted to the real physical environment at the moment t2, an optimal simulation result may be selected from these simulation results as the target simulation result. For example, the optimal simulation result is that time used for passing an intersection is the shortest.

In some embodiments, if none of the simulation results in the plurality of physical simulation environments meets the preset effect requirement, or there is no simulation result that can be adapted to the real physical environment at the moment t2 and whose simulation effect meets the preset effect requirement, the computing device cluster 10 may reconstruct a plurality of physical simulation environments based on the first feature information, and reconstruct a digital twin device based on the second feature information, to reselect the target simulation result and regenerate the decision model.

In some embodiments, if the computing device cluster 10 obtains first feature information of a plurality of historical real physical environments, the decision model may be used by the electronic device 20 to make a decision in a current real physical environment, and may also be used by the electronic device 20 to make a decision in another similar real physical environment. The computing device cluster 10 may obtain the decision model through training based on simulation results of the digital twin device in a plurality of physical simulation environments corresponding to the plurality of historical real physical environments.

Step S56: Feed back the decision model to the electronic device 20.

In some embodiments, after receiving the decision model, the electronic device 20 may make the decision in the current real physical environment by using the decision model. If the decision made by the electronic device 20 in the current real physical environment by using the decision model cannot achieve the expected benefit, it may be considered that the decision model is not applicable to the current real physical environment, and the computing device cluster 10 may perform steps S51 to S57 again. If the decision made by the electronic device 20 in the current real physical environment by using the decision model achieves the expected benefit, it may be considered that the decision model is applicable to the current real physical environment, and the current simulation decision can be ended.

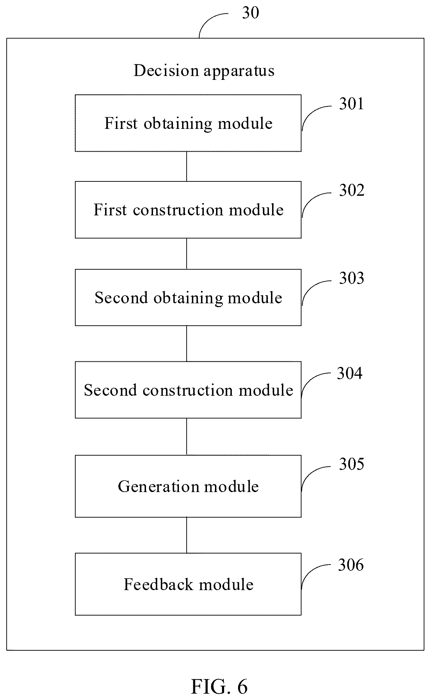

FIG. 6 shows a decision apparatus 30 according to an embodiment of this application. The decision apparatus 30 may include a first obtaining module 301, a first construction module 302, a second obtaining module 303, a second construction module 304, a generation module 305, and a feedback module 306.

The first obtaining module 301 is configured to obtain first feature information of a historical real physical environment, where the first feature information includes environment data in a plurality of dimensions collected in the historical real physical environment.

The first construction module 302 is configured to construct a plurality of physical simulation environments based on the first feature information, where each physical simulation environment is constructed by using different environment data adjustment policies.

The second obtaining module 303 is configured to obtain second feature information of an electronic device located in the historical real physical environment, where the second feature information includes body status data of the electronic device in a plurality of dimensions in the historical real physical environment.

The second construction module 304 is configured to construct a digital twin device of the electronic device in a simulation system based on the second feature information.

The generation module 305 is configured to obtain a decision model based on simulation results of the digital twin device in the plurality of physical simulation environments.

The feedback module 306 is configured to feed back the decision model to the electronic device 20, so that the electronic device 20 makes a decision in a current real physical environment by using the decision model.

The first obtaining module 301, the first construction module 302, the second obtaining module 303, the second construction module 304, the generation module 305, and the feedback module 306 may all be implemented by software, or may be implemented by hardware. For example, the following uses the first obtaining module 301 as an example to describe an implementation of the first obtaining module 301. Similarly, for implementations of the first construction module 302, the second obtaining module 303, the second construction module 304, the generation module 305, and the feedback module 306, refer to the implementation of the first obtaining module 301.

When a module is used as an example of a software functional unit, the first obtaining module 301 may include code that runs on a computing instance. The computing instance may include at least one of a physical host (a computing device), a virtual machine, and a container. Further, there may be one or more computing instances. For example, the first obtaining module 301 may include code that runs on a plurality of hosts/virtual machines/containers. It should be noted that, the plurality of hosts/virtual machines/containers configured to run the code may be distributed in a same region (region), or may be distributed in different regions. Further, the plurality of hosts/virtual machines/containers configured to run the code may be distributed in a same availability zone (availability zone, AZ), or may be distributed in different AZs. Each AZ includes one data center or a plurality of data centers that are geographically close to each other. Usually, one region may include a plurality of AZs.

Similarly, the plurality of hosts/virtual machines/containers configured to run the code may be distributed on a same virtual private cloud (virtual private cloud, VPC), or may be distributed on a plurality of VPCs. Usually, one VPC is disposed in one region. For cross-region communication between two VPCs in a same region and between VPCs in different regions, a communication gateway needs to be disposed in each of the VPCs, and interconnection between the VPCs is implemented through the communication gateway.

When a module is used as an example of a hardware functional unit, the first obtaining module 301 may include at least one computing device, for example, a server. Alternatively, the first obtaining module 301 may be a device implemented by using an application-specific integrated circuit (application-specific integrated circuit, ASIC) or a programmable logic device (programmable logic device, PLD), or the like. The PLD may be implemented by a complex programmable logic device (complex programmable logic device, CPLD), a field-programmable gate array (field-programmable gate array, FPGA), generic array logic (generic array logic, GAL), or any combination thereof.

A plurality of computing devices included in the first obtaining module 301 may be distributed in a same region, or may be distributed in different regions. The plurality of computing devices included in the first obtaining module 301 may be distributed in a same AZ, or may be distributed in different AZs. Similarly, the plurality of computing devices included in the first obtaining module 301 may be distributed on a same VPC, or may be distributed on a plurality of VPCs. The plurality of computing devices may be any combination of computing devices such as a server, an ASIC, a PLD, a CPLD, an FPGA, and a GAL.

It should be noted that, in another embodiment, the first obtaining module 301 may be configured to perform any step in the decision method, the first construction module 302 may be configured to perform any step in the decision method, the second obtaining module 303 may be configured to perform any step in the decision method, the second construction module 304 may be configured to perform any step in the decision method, the generation module 305 may be configured to perform any step in the decision method, and the feedback module 306 may be configured to perform any step in the decision method. Steps implemented by the first obtaining module 301, the first construction module 302, the second obtaining module 303, the second construction module 304, the generation module 305, and the feedback module 306 may be specified based on a requirement. The first obtaining module 301, the first construction module 302, the second obtaining module 303, the second construction module 304, the generation module 305, and the feedback module 306 respectively implement different steps in the decision method, to implement all functions of the decision apparatus 30.

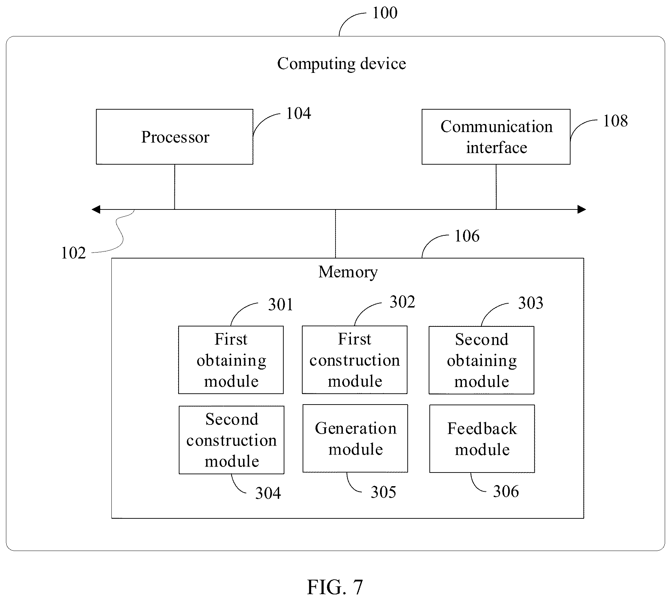

FIG. 7 shows a computing device 100 according to an embodiment of this application. The computing device 100 includes a bus 102, a processor 104, a memory 106, and a communication interface 108. The processor 104, the memory 106, and the communication interface 108 communicate with each other through the bus 102. The computing device 100 may be a server or a terminal device. It should be understood that a quantity of processors and a quantity of memories in the computing device 100 are not limited in this application.

The bus 102 may be a peripheral component interconnect (peripheral component interconnect, PCI) bus, an extended industry standard architecture (extended industry standard architecture, EISA) bus, or the like. Buses may be classified into an address bus, a data bus, a control bus, and the like. For ease of representation, the bus is represented by using only one line in FIG. 7. However, it does not mean that there is only one bus or only one type of bus. The bus 104 may include a path for transmitting information between the components (for example, the memory 106, the processor 104, and the communication interface 108) of the computing device 100.

The processor 104 may include any one or more of processors such as a central processing unit (central processing unit, CPU), a graphics processing unit (graphics processing unit, GPU), a microprocessor (microprocessor, MP), or a digital signal processor (digital signal processor, DSP).

The memory 106 may include a volatile memory (volatile memory), for example, a random access memory (random access memory, RAM). The processor 104 may further include a non-volatile memory (non-volatile memory), for example, a read-only memory (read-only memory, ROM), a flash memory, a hard disk drive (hard disk drive, HDD), or a solid-state drive (solid-state drive, SSD).

The memory 106 stores executable program code, and the processor 104 executes the executable program code to separately implement functions of the first obtaining module 301, the first construction module 302, the second obtaining module 303, the second construction module 304, the generation module 305, and the feedback module 306, to implement the decision method. In other words, the memory 106 stores instructions used to perform the decision method. In FIG. 7, an example in which the processor 104 executes the executable program code to separately implement the functions of the first obtaining module 301, the first construction module 302, the second obtaining module 303, the second construction module 304, the generation module 305, and the feedback module 306 is used.

The communication interface 108 implements communication between the computing device 100 and another device or a communication network by using a transceiver module, for example, but not limited to a network interface card or a transceiver.

An embodiment of this application further provides a computing device cluster 10. The computing device cluster 10 includes at least one computing device. The computing device may be a server configured to store data, or a local server in a local data center. In some embodiments, the computing device may alternatively be a terminal device, for example, a desktop computer, a notebook computer, or a smartphone.

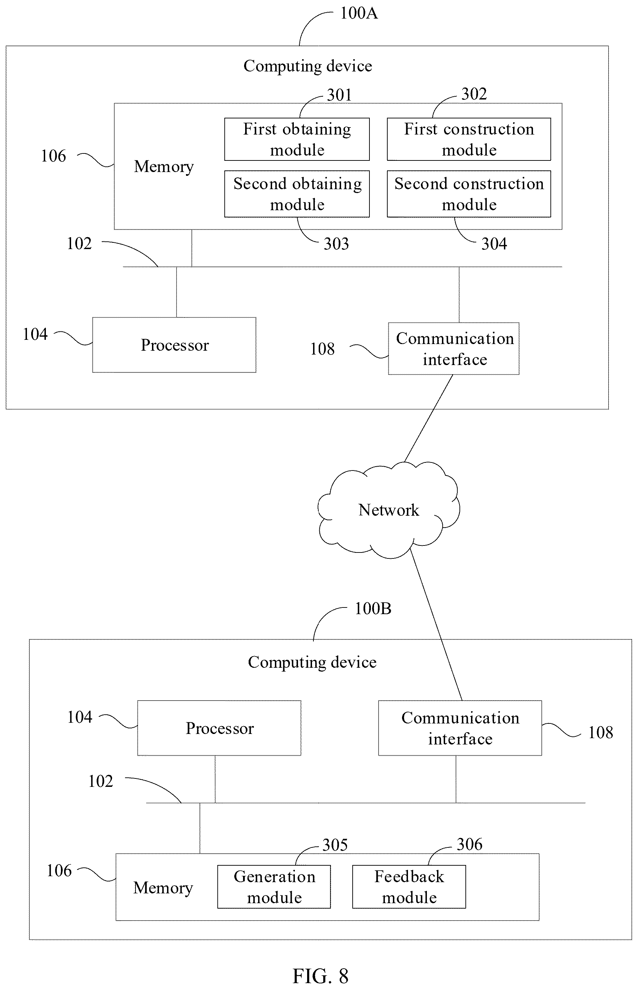

As shown in FIG. 8, the computing device cluster 10 includes at least one computing device 100. A memory 106 in one or more computing devices 100 in the computing device cluster 10 may store same instructions for performing the decision method.

In some possible implementations, the memory 106 in the one or more computing devices 100 in the computing device cluster 10 may alternatively separately store some instructions for performing the decision method. In other words, a combination of the one or more computing devices 100 may jointly execute instructions for performing the decision method.

It should be noted that memories 106 in different computing devices 100 in the computing device cluster 10 may store different instructions, and different instructions are separately used to perform some functions of the decisionapparatus. That is, the instructions stored in the memories 106 in different computing devices 100 may implement functions of one or more of the first obtaining module 301, the first construction module 302, the second obtaining module 303, the second construction module 304, the generation module 305, and the feedback module 306.

In some possible implementations, the one or more computing devices in the computing device cluster 10 may be connected through a network. The network may be a wide area network, a local area network, or the like. FIG. 8 shows a possible implementation. As shown in FIG. 8, two computing devices 100A and 100B are connected through a network, to implement the functions of one or more modules of the first obtaining module 301, the first construction module 302, the second obtaining module 303, the second construction module 304, the generation module 305, and the feedback module 306. Specifically, each computing device is connected to the network through a communication interface in the computing device. In this possible implementation, a memory 106 in the computing device 100A stores instructions for performing the functions of the first obtaining module 301, the first construction module 302, the second obtaining module 303, and the second construction module 304. In addition, a memory 106 in the computing device 100B stores instructions for performing the functions of the generation module 305 and the feedback module 306.

A connection manner between the computing devices of computing device clusters 10 shown in FIG. 8 may be based on a consideration that a large amount of data needs to be stored and read in the decision method provided in this application. Therefore, the functions implemented by the generation module 305 and the feedback module 306 are considered to be performed by the computing device 100B.

It should be understood that functions of the computing device 100A shown in FIG. 8 may alternatively be completed by a plurality of computing devices 100. Similarly, functions of the computing device 100B may alternatively be completed by the plurality of computing devices 100.

An embodiment of this application further provides a decision system, including a computing device cluster 10 and an electronic device 20. A simulation system runs in the computing device cluster.

An embodiment of this application further provides a computer program product including instructions. The computer program product may be software or a program product that includes the instructions and that can run on a computing device or be stored in any usable medium. When the computer program product runs on at least one computing device, the at least one computing device is enabled to perform the decision method.

An embodiment of this application further provides a computer-readable storage medium. The computer-readable storage medium may be any usable medium that can be stored by a computing device, or a data storage device, such as a data center, including one or more usable media. The usable medium may be a magnetic medium (for example, a floppy disk, a hard disk, or a magnetic tape), an optical medium (for example, a DVD), a semiconductor medium (for example, a solid-state drive), or the like. The computer-readable storage medium includes instructions, and the instructions instruct the computing device to perform the decision method.

The foregoing descriptions about implementations allow a person skilled in the art to clearly understand that, for the purpose of convenient and brief description, division of the foregoing functional modules is used as an example for illustration. During actual application, the foregoing functions can be allocated to different functional modules and implemented based on a requirement, that is, an inner structure of an apparatus is divided into different functional modules to implement all or some of the functions described above.

In several embodiments provided in this application, it should be understood that the disclosed apparatus and method may be implemented in other manners. For example, the described apparatus embodiments are examples. For example, division into the modules or units is logical function division and may be other division during actual implementation. For example, a plurality of units or components may be combined or integrated into another apparatus, or some features may be ignored or not performed. In addition, the displayed or discussed mutual couplings or direct couplings or communication connections may be implemented by using some interfaces. The indirect couplings or communication connections between apparatuses or units may be implemented in electronic, mechanical, or other forms.

The units described as separate parts may or may not be physically separate, and parts displayed as units may be one or more physical units, may be located in one place, or may be distributed on different places. Some or all of the units may be selected based on an actual requirement to achieve the objectives of the solutions of embodiments.

In addition, functional units in embodiments of this application may be integrated into one processing unit, each of the units may exist alone physically, or two or more units may be integrated into one unit. The integrated unit may be implemented in a form of hardware, or may be implemented in a form of a software functional unit.

When the integrated unit is implemented in the form of a software functional unit and sold or used as an independent product, the integrated unit may be stored in a readable storage medium. Based on such an understanding, the technical solutions in embodiments of this application essentially, or the part contributing to the current technology, or all or some of the technical solutions may be implemented in a form of a software product. The software product is stored in a storage medium and includes several instructions for instructing a device (which may be a single-chip microcomputer, a chip, or the like) or a processor to perform all or some of the steps of the methods described in embodiments of this application. The foregoing storage medium includes any medium that can store program code, such as a USB flash drive, a removable hard disk, a read-only memory, a random access memory, a magnetic disk, or an optical disc.

The foregoing descriptions are merely specific implementations of this application, but are not intended to limit the protection scope of this application. Any variation or replacement within the technical scope disclosed in this application shall fall within the protection scope of this application.

## Claims

1. A decision method, applied to a simulation system, wherein the method comprises:
obtaining first feature information of a historical real physical environment, wherein the first feature information comprises environment data in a plurality of dimensions collected in the historical real physical environment;
constructing a plurality of physical simulation environments based on the first feature information, wherein each physical simulation environment is constructed by using different environment data adjustment policies;
obtaining second feature information of an electronic device located in the historical real physical environment, wherein the second feature information comprises body status data of the electronic device in a plurality of dimensions in the historical real physical environment;
constructing a digital twin device of the electronic device in the simulation system based on the second feature information;
obtaining a decision model based on simulation results of the digital twin device in the plurality of physical simulation environments; and
feeding back the decision model to the electronic device.

2. The decision method according to claim 1, wherein constructing the plurality of physical simulation environments based on the feature information of the historical real physical environment comprises:
preprocessing the first feature information, wherein the preprocessing comprises correcting environment data with an anomaly and/or adjusting precision of the environment data; and
constructing the plurality of physical simulation environments based on the preprocessed first feature information.

3. The decision method according to claim 2, wherein constructing the plurality of physical simulation environments based on the preprocessed first feature information comprises:
constructing a first physical simulation environment based on the preprocessed first feature information; and
modifying environment data in one or more dimensions in the first physical simulation environment to obtain a plurality of second physical simulation environments.

4. The decision method according to claim 3, wherein the method further comprises:
determining a corner case environment corresponding to the historical real physical environment; and
adjusting the environment data of the first physical simulation environment based on the corner case environment to obtain a corner case simulation environment.

5. The decision method according to claim 1, wherein constructing the digital twin device of the electronic device in the simulation system based on the second feature information comprises:
preprocessing the second feature information, wherein the preprocessing comprises correcting body status data with an anomaly and/or adjusting precision of the body status data; and
constructing the digital twin device of the electronic device in the simulation system based on the preprocessed second feature information.

6. The decision method according to any one of claims 1 to 5, wherein obtaining the decision model based on the simulation results of the digital twin device in the plurality of physical simulation environments comprises:
obtaining, through screening the simulation results of the digital twin device in the plurality of physical simulation environments, a simulation result that meets a preset effect requirement;
selecting, from the simulation result that meets the preset effect requirement, a simulation result adapted to a current real physical environment of the electronic device as a target simulation result; and
obtaining the decision model based on the target simulation result.

7. The decision method according to claim 6, wherein the method further comprises:
if none of the simulation results in the plurality of physical simulation environments meets the preset effect requirement, or no simulation result is adapted to the current real physical environment of the electronic device and meets the preset effect requirement, reconstructing a plurality of physical simulation environments based on the first feature information, and reconstructing a digital twin device of the electronic device in the simulation system based on the second feature information; and
reselecting the target simulation result and regenerating the decision model based on simulation results of the reconstructed digital twin device in the plurality of reconstructed physical simulation environments.

8. A decision apparatus, wherein the apparatus comprises:
a first obtaining module, configured to obtain first feature information of a historical real physical environment, wherein the first feature information comprises environment data in a plurality of dimensions collected in the historical real physical environment;
a first construction module, configured to construct a plurality of physical simulation environments based on the first feature information, wherein each physical simulation environment is constructed by using different environment data adjustment policies;
a second obtaining module, configured to obtain second feature information of an electronic device located in the historical real physical environment, wherein the second feature information comprises body status data of the electronic device in a plurality of dimensions in the historical real physical environment;
a second construction module, configured to construct a digital twin device of the electronic device in a simulation system based on the second feature information;
a generation module, configured to obtain a decision model based on simulation results of the digital twin device in the plurality of physical simulation environments; and
a feedback module, configured to feed back the decision model to the electronic device.

9. A decision system, comprising a computing device and an electronic device, wherein a simulation system runs on the computing device;
the computing device is configured to:
obtain first feature information of a historical real physical environment, wherein the first feature information comprises environment data in a plurality of dimensions collected in the historical real physical environment;
construct a plurality of physical simulation environments based on the first feature information, wherein each physical simulation environment is constructed by using different environment data adjustment policies;
obtain second feature information of an electronic device located in the historical real physical environment, wherein the second feature information comprises body status data of the electronic device in a plurality of dimensions in the historical real physical environment;
construct a digital twin device of the electronic device in the simulation system based on the second feature information;
obtain a decision model based on simulation results of the digital twin device in the plurality of physical simulation environments; and
feed back the decision model to the electronic device; and
the electronic device is configured to make, by using the decision model, a decision in a current real physical environment in which the electronic device is located.

10. A computing device cluster, comprising at least one computing device, wherein each computing device comprises a processor and a memory; and
the processor of the at least one computing device is configured to execute instructions stored in the memory of the at least one computing device, to enable the computing device cluster to perform the decision method according to any one of claims 1 to 7.

11. A computer program product comprising instructions, wherein when the instructions are executed by a computing device cluster, the computing device cluster is enabled to perform the decision method according to any one of claims 1 to 7.

12. A computer-readable storage medium, comprising computer program instructions, wherein when the computer program instructions are executed by a computing device cluster, the computing device cluster performs the decision method according to any one of claims 1 to 7.
